Europäisches Patentamt

European Patent Office

Office européen des brevets

(19)

(11) Veröffentlichungsnummer : **0 054 106**
B1

(12) # EUROPÄISCHE PATENTSCHRIFT

(45) Veröffentlichungstag der Patentschrift :
26.06.85

(21) Anmeldenummer : 81106990.5

(22) Anmeldetag : 07.09.81

(51) Int. Cl.⁴ : **H 03 K 4/69, H 03 K 6/02, H 03 K 6/04**

(54) **Ablenkverstärker mit Korrektur nicht symmetrischer Verzerrungen.**

(30) Priorität : 13.12.80 DE 3047081

(43) Veröffentlichungstag der Anmeldung :
23.06.82 Patentblatt 82/25

(45) Bekanntmachung des Hinweises auf die Patenterteilung : 26.06.85 Patentblatt 85/26

(84) Benannte Vertragsstaaten :
CH DE FR GB LI

(56) Entgegenhaltungen :
DE-B- 2 751 174
US-A- 4 188 567

(73) Patentinhaber : ROBERT BOSCH GMBH
Postfach 50
D-7000 Stuttgart 1 (DE)

(72) Erfinder : Siegmar, Winfried
Einsteinweg 42
D-7310 Plochingen (DE)

EP 0 054 106 B1

## Beschreibung

### Stand der Technik

Die Erfindung geht aus von einem Ablenkverstärker nach der Gattung des Hauptanspruches. Ablenkverstärker sind bereits aus der Fernsehtechnik bekannt. Zur Behebung des insbesondere bei handelsüblichen Fernsehgeräten in horizontaler Ablenkrichtung auftretenden sogenannten Tangensfehler ist üblicherweise ein Korrektursystem vorgesehen, das aus stromabhängigen Induktivitäten oder Kondensatoren besteht. Die Verwendung von stromabhängigen Induktivitäten, die vom Ablenkstrom selber durchflossen werden, hat den Nachteil, daß sie zusätzliche Ablenkenergie benötigen. Weiterhin sind Induktivitäten oder Kondensatoren dann nicht einsetzbar, wenn mit einer variablen Ablenkfrequenz gearbeitet wird, wie sie insbesondere bei Datensichtgeräten, bei Diagnosegeräten in der Kraftfahrzeugindustrie Verwendung finden. Aus der US-A-4 188 567 und aus der DE-B-27 51 174 ist es bereits bekannt, bei Ablenkverstärkern im Rückkopplungszweig ein Widerstandsdiodenetzwerk vorzusehen, um damit den Tangensfehler zu beheben. In vielen Anwendungsfällen ist diese Maßnahme jedoch nicht ausreichend. Insbesondere ist durch das Anordnen nur eines Widerstandes und nur einer Diode in vielen Fällen nur eine unzureichende Entzerrung gegeben, zum anderen treten bei einer Verschiebung des Bildes auf dem Bildschirm wiederum Verzerrungen auf, da durch die bekannten Maßnahmen nur eine Entzerrung bei einem bestimmten schirmbild möglich ist.

Es ist daher Aufgabe der Erfindung, die bekannten Ablenkverstärker dahingehend zu verbessern, daß die Linearität der Darstellung auf dem Bildschirm erhöht wird und eine lageabhängige Korrektur gegeben ist.

### Vorteile der Erfindung

Die erfindungsgemäße Anordnung mit den kennzeichnenden Merkmalen des Hauptanspruchs hat den Vorteil, daß eine hohe Linearität der Darstellung erzielt wird und der Einsatzpunkt der einzelnen Rückkopplungsglieder in Abhängigkeit zur Lage des Elektronenstrahls konstant gehalten wird. Dadurch ist auch bei einem Verschieben des Elektronenstrahls und einer Änderung des Arbeitspunktes des Verstärkers gewährleistet, daß immer bei einem vorgegebenen Ablenkpunkt der Einsatzpunkt der Dioden liegt. Vorteilhafterweise sind hierzu eine der Lage des Elektronenstrahls proportionale Spannung in den Gegenkopplungsweig eingespeist. Hierzu eignet sich besonders vorteilhaft die vom Lagesteller abgegriffene Spannung. Um mit einer geringen Anzahl von Bauelementen auszukommen ist es günstig, die der Lage proportionale Spannung einem Spannungsteiler zuzuführen, von dem ein Widerstand dem Innenwiderstand des Rückkopplungseingangs des Verstärkers entspricht. Durch die Varianten der Polarität der Dioden in der Gestaltung ist bestimmbar, welche der Halbwellen des Ablenkstromes beeinflussen wird.

### Zeichnung

Ausführungsbeispiele der Erfindung sind in der Zeichnung dargestellt und in der nachfolgenden Beschreibung näher erläutert. Es zeigen Fig. 1 ein Blockschaltbild eines Bildsichtgerätes, Fig. 2 einen Ablenkverstärker mit Gegenkopplungszweig, Fig. 3 ein Beispiel einer erfindungsgemäßen Ausgestaltung des Gegenkopplungszweigs und Fig. 4 ein weiteres Beispiel einer erfindungsgemäßen Ausgestaltung des Gegenkopplungszweiges.

### Beschreibung der Ausführungsbeispiele

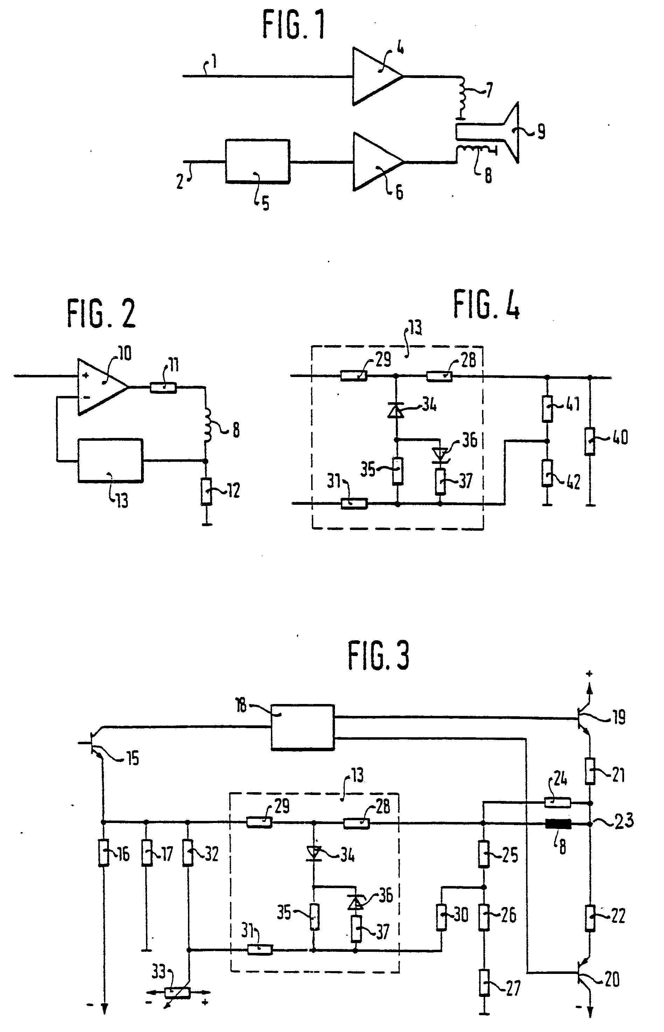

In Fig. 1 ist auszugsweise das Blockschaltbild eines Bildsichtgerätes dargestellt. Am Vertikaleingang 1 liegen die Vertikalsynchronimpulse oder eine Spannung an, die durch den Vertikalverstärker 4 verstärkt werden. Der Vertikalverstärker 4 liefert am Ausgang einen Strom, mit dem die Vertikalablenkspule 7 gespeist wird. Die Vertikalablenkspule 7 bildet mit einer Horizontalablenkspule 8 das magnetische Ablenksystem einer Bildröhre 9. An einem Horizontaleingang 2 liegen die Horizontalimpulse an, die einem Sägezahngenerator 5 zugeführt werden. Der Ausgang des Sägezahngenerators 5 steht mit dem Eingang eines Horizontalverstärkers 6 in Verbindung, der seinerseits die Horizontalablenkspule 8 speist.

Das am Eingang 1 anliegende Vertikalsignal ist entweder die darzustellende Spannung, wenn das Bildsichtgerät als Oszillograph Verwendung findet, oder es liegen die vertikalen Synchronimpulse an, die mittels des Verstärkers in eine für die vertikale Ablenkspule 7 geeignete Vertikalspannung umgewandelt werden. Am Horizontalverstärkereingang 2 liegen die horizontalen Ablenkimpulse an, die den Sägezahngenerator 5 synchronisieren. Der Verstärker 6 wandelt die am Ausgang des Sägezahngenerators 5 anliegenden Sägezahnimpulse in einen Strom um, der zur Speisung der Horizontalablenkspule 8 dient. Insbesondere bei dieser horizontalen Ablenkung tritt der sogenannte Tangensfehler sehr störend auf, wenn der Elektronenstrahl mit Hilfe eines linear ab- oder zunehmenden Magnetfeldes abgelenkt wird. Dieser Fehler kommt dadurch zustande, daß der Elektronenstrahl nur bei einem kugelförmigen Bildschirm von der emittierenden Elektrode den gleichen Weg zurücklegen muß, während bei dem nahezu planen Bildschirm die Laufzeiten unterschiedlich sind. Zur Korrektur dieses Tangensfehlers wird daher insbesondere die Horizontalablenkspule jedoch auch in geringerem Maße die Vertikalablenkspule mit einem nicht linear zu- oder abnehmenden Magnetfeld angesteuert. Hierzu werden stromabhängige Induktivitäten oder Kondensatoren verwendet. Diese Maßnahmen versagen jedoch ganz oder teilweise bei Testgeräten oder Bildsichtgeräten, bei denen mit schwankenden horizontalen Ablenkfrequenzen gearbeitet werden muß, da Induktivitäten und Kondensatoren in Abhängigkeit von der Frequenz ihre Eigenschaften ändern. Beispielsweise ändert sich die Frequenz der Horizontalimpulse am Eingang 2 bei Motortestgeräten, wie sie beispielsweise in der Kraftfahrzeugdiagnosetechnik Verwendung finden, im Bereich zwischen 10 und 400 Hz.

In Fig. 2 ist daher die prinzipielle Schaltungsanordnung eines Horizontalverstärkers dargestellt, der ohne stromabhängige Induktivitäten auskommt. Der Ausgang des Sägezahngenerators 5 gelangt hier an den nicht invertierenden Eingang eines Differenzverstärkers 10, dessen Ausgang über einen Widerstand 11 mit der Horizontalablenkspule 8 verbunden ist. Die Horizontalablenkspule 8 steht über einen weiteren Widerstand 12 mit der Gerätemasse in Verbindung. Zwischen Horizontalablenkspule 8 und Widerstand 12 führt eine Leitung zu einem Gegenkopplungszweig 13, dessen Ausgang mit dem invertierenden Eingang des Differenzverstärkers 10 verbunden ist. Die am Widerstand 12 abfallende Spannung ist die den Gegenkopplungszweig 13 steuernde Spannung.

In Fig. 3 ist ein Horizontalverstärker entsprechend Fig. 2 dargestellt. An der Basis eines Transistors 15 liegt ein Sägezahnsignal vom Sägezahngenerator 5 an. Der Emitter des Transistors 15 ist über einen Widerstand 16 mit der negativen Versorgungsspannung verbunden. Ein weiterer Widerstand 17 ist einerseits an den Emitter des Transistors 15 angeschlossen, andererseits mit der Masse verbunden. Der Kollektor des Transistors 15 ist an den Eingang eines Zwischenverstärkers 18 angeschlossen, dessen Ausgang die Endstufentransistoren 19 und 20 ansteuert, die im Gegentakt geschaltet sind. Die Ausgänge des Zwischenverstärkers 18 führen daher zu den Basen der Transistoren 19 und 20. Der Kollektor des Transistors 19 ist mit der positiven Betriebsspannung, der Kollektor des Transistors 20 mit der negativen Betriebsspannung verbunden. Der Emitter des Transistors 19 führt über einen Widerstand 21, der Emitter des Transistors 20 über einen Widerstand 22 zu einem Verbindungspunkt 23, der den Ausgang des Verstärkers darstellt. Der Verbindungspunkt 23 steht einerseits mit einem Widerstand 24, andererseits mit der Horizontalablenkspule 8 in Verbindung. Die Horizontalablenkspule 8 und der Widerstand 24 sind parallel geschaltet und über ein Widerstands-Netzwerk mit den Widerständen 25, 26 und 27 mit der Masse verbunden. Zwischen Widerstand 24 und 25 führt eine Leitung zum Gegenkopplungszweig 13, mit einem Widerstand 28. Ein dem Widerstand 28 folgender Widerstand 29 steht mit dem Emitter des Transistors 15 in Verbindung. Zum Gegenkopplungszweig führt des weiteren ein Widerstand 30, der einerseits zwischen den Widerständen 25 und 26 angeschlossen ist und andererseits über einen Widerstand 31 und einen Widerstand 32 mit dem Emitter des Transistors 15 in Verbindung steht. Zwischen Widerständen 31 und 32 ist der Mittelabgriff eines Potentiometers 33 angeschlossen, während die beiden anderen Punkte des Potentiometers 33 mit der positiven und der negativen Versorgungsspannung verbunden sind. Das Potentiometer 23 dient zur Einstellung der Lage des Elektronenstrahls. Zwischen den Widerständen 28 und 29 und 30 und 31 ist ein Widerstands-Diodennetzwerk geschaltet, wobei von den Widerständen 28 und 29 die Diode 34 ausgeht, die einerseits über einen Widerstand 35, andererseits über eine Zenerdiode 36 und einen Widerstand 37 zwischen den Widerständen 30 und 31 angeschlossen ist.

Die an der Basis des Transistors 15 anliegende Sägezahnspannung wird durch den Zwischenverstärker 18 verstärkt und den Endstufentransistoren 19 und 20 zugeführt, die ihrerseits die Ablenkspule 8 ansteuern. Der Ansteuerstrom fließt über die Widerstände 25, 26 und 27 zur Masse ab. Zwei Abgriffe am Widerstand 25 dienen zur Ansteuerung des Gegenkopplungsnetzwerkes. Befindet sich der Sägezahn in einem niedrigen Spannungsbereich, d. h. fließt nur ein geringer Strom durch die Ablenkspule 8, so fällt auch am Widerstand 25 nur eine geringe Spannung ab. Die Diode 34 ist noch in gesperrtem Zustand, so daß die Widerstände 35 und 37 keinen Einfluß auf die Gegenkopplung nehmen können. Das Verhalten des Gegenkopplungszweiges 13 ist daher durch die Widerstände 28 und 29 und die Widerstände 30 und 31 bestimmt. Steigt nun aufgrund des Sägezahnes der Strom durch die Ablenkspule 8 an, so wird zu einem vorgegebenen Zeitpunkt die durchbruchspannung der Diode 34 erreicht, so daß im Gegenkopplungszweig der Widerstand 35 mit Strom durchflossen wird und wirksam wird. Steigt der Strom durch die Ablenkspule 8 weiter an, so wird auch der Spannungsabfall am Widerstand 25 größer, so daß nach einer gewissen Zeit der Zeitpunkt eintritt, an dem die Zenerspannung der Zenerdiode 36 überschritten wird. In diesem Fall wird der Wert des Widerstands 35 durch den Wert des Widerstandes 37 herabgesetzt. Durch das spannungsgesteuerte Parallelschalten des Widerstandes 35 und später des Widerstandes 37 zu den Gegenkopplungswiderständen 28 und 29 wird die Verstärkung und damit der Ablenkstrom in Abhängigkeit vom Stand des Sägezahnes bzw. dem Ort des Elektronenstrahles auf dem Bildschirm herabgesetzt. Die steuernde Spannung, die mit den Dioden 34 und 36 den Einsetzpunkt der Verstärkungsumschaltung bestimmt, wird dabei an den Widerständen 25, 26 und 27 abgegriffen. Die Polararität der Dioden 34 und 36 bestimmt, ob die positive oder negative Halbwelle des Ablenkstroms beeinflußt werden soll. Die Widerstände 30 und 31 dienen im wesentlichen dazu, eine Verschiebung des Einsatzpunktes dann zu bewirken, wenn beispielsweise mittels des Lagepotentiometers 33 der Einsatzpunkt der gesamten Verstärkungsanordnung verändert wird. Durch eine Verstellung des Potentiometers 33, wird das Potential am Emitter des Transistors 15 verändert, wodurch der Einsatzpunkt des Verstärkers und damit die Lage des Strahls auf dem Bildschirm in horizontaler Richtung verändert werden kann. Um nun einen örtlich unabhängigen Einsatzpunkt der Gegenkopplung auch bei einer Änderung der Lage zu verhindern, d. h. den Ablenkstrom immer beim gleichen Wert zu beeinflussen, muß das Potential am Fußpunkt der Widerstände 35 und 37 im gleichen Maße geändert werden wie die Spannung am Emitter des Transistors 15. Dies wird durch die Widerstände 30 und 31 erreicht. Der Widerstand 30 hat dabei vorzugsweise den gleichen Wert wie der innere Widerstand am Emitter des Transistors 15 und kann auch durch den Innenwiderstand des Spannungsteilers für den Einsatzpunkt der Verstärkungsänderung realisiert werden. Jedoch sind die Widerstände 25, 26 und 27 in der vorgegebenen Beschaltung meist sehr niederohmig, so daß der Widerstand 30 vorgesehen werden muß, wenn nicht eine Beschaltung nach Fig. 4 gewählt wird. Eine einfache Spannungsänderung wird bereits durch die Diode 34 und den Widerstand 35 erzielt. Eine zweistufige Verstellung wird durch das Hinzufügen der Zenerdiode 36 und den Widerstand 37 erreicht. Durch das Hinzuschalten weiterer Dioden-Widerstands-Netzwerke ist es möglich, eine beliebige Anzahl von Abstufungen vorzunehmen, wobei der Einsatzpunkt jeweils durch den Wert der Zenerdioden bestimmt ist. Es ist daher möglich, weitere Zenerdioden 36 und Widerstände 37 parallel zu schalten, so daß auch feinere Abstufungen möglich sind. Der Wert der Widerstände 35 and 37 bestimmt zudem die Wirkung der Abstufung. Bei dem gezeigten Gegenkopplungszweig wirken die Widerstände 35 und 37 nur in Form einer Verkleinerung des Widerstands 28. Durch die Wahl eines entsprechenden Verhältnisses der Widerstände 28 und 29 zueinander oder durch ein vollkommenes Weglassen des Widerstandes 29 ist erreichbar, daß das Dioden-Widerstands-Netzwerk entweder auf den gesamten Gegenkopplungszweig einwirkt oder nur auf einen Teilbereich, wobei die Intensität wiederum durch die Wahl des Verhältnisses der Widerstände 28 und 29 zueinander abstimmbar ist.

In Fig. 4 ist ausschnittsweise ein weiteres Ausführungsbeispiel eines Gegenkopplungszweiges dargestellt. Von der Ablenkspule 8 ausgehend ist ein Widerstand 40 gegen Masse geschaltet, der die Widerstände 25, 26 und 27 ersetzt. Des weiteren ist an die Ablenkspule 8 ein Spannungsteiler mit den Widerständen 41 und 42 angeschlossen, wobei der Widerstand 42 mit der Masse in Verbindung steht. Der Gegenkopplungszweig 13 weist wiederum in Reihenschaltung die Widerstände 28 und 29 auf, wobei Widerstand 28 mit der nicht dargestellten Ablenkspule 8, der Widerstand 29 mit dem nicht dargestellten Emitter des Transistors 15 verbunden ist. Zwischen Widerständen 41 und 42 führt eine Leitung zum Widerstand 31, der seinerseits mit dem Mittelabgriff des nicht dargestellten Potentiometers 33 verbunden ist. Zwischen Widerstand 28 und Widerstand 29 ist wiederum eine Diode 34 angeschlossen, die einerseits über einen Widerstand 35, andererseits über eine Zenerdiode 36 und einen Widerstand 37 mit der Leitung zwischen Widerstand 41 und Widerstand 31 verbunden ist. Der Gegenkopplungszweig 13 ist wie der in Fig. 3 aufgebaut, jedoch weisen die Dioden 34 und 36 eine andere Polarität auf, so daß die entgegengesetzte Halbwelle des Ablenkstromes beeinflußt wird. Als Spannungsteiler wird hier nicht der Lastwiderstand 40 sondern zusätzliche Widerstände 41 und 42 verwendet, wobei diese beiden Widerstände zur Stabilisierung des Einsatzpunktes den Innenwiderstand am Emitter des Transistors 15 aufweisen. Die Funktionsweise der Schaltungsanordnung entspricht der der Fig. 3, so daß auf die entsprechende Beschreibung verwiesen wird.

**Patentansprüche**

1. Ablenkverstärker für Ablenkspulen einer Bildröhre für Bildsichtgeräte mit einer Gegenkopplung, die als Widerstands-Diodennetzwerk ausgebildet ist, wobei einem Widerstand mindestens ein weiterer Widerstand parallel geschaltet ist, dessen Einsatzpunkt durch jeweils eine Diode vorzugsweise unterschiedlicher Durchbruchsspannung bestimmt ist, so daß das Widerstands-Diodennetzwerk nur teilweise in den Gegenkopplungszweig eingreift, dadurch gekennzeichnet, daß die Lage des Elektronenstrahles einstellbar ist und eine der Veränderung der Lage des Elektronenstrahles proportionale Spannung dem Gegenkopplungszweig (13) zugeführt wird, die den Einsatzpunkt der Dioden (34, 36) mit dem Einsatzpunkt der Verstärkungsänderung so verschiebt, daß der Einsatzpunkt in Abhängigkeit von der Lage des Elektronenstrahles konstant gehalten wird.

2. Ablenkverstärker nach Anspruch 1, dadurch gekennzeichnet, daß durch die Polarität der Dioden (34, 36) die Halbwelle des Ablenkstromes auswählbar ist.

3. Ablenkverstärker nach einem der Ansprüche 1 oder 2, dadurch gekennzeichnet, daß die der Lage des Elektronenstrahles proportionale Spannung einem Lagepotentiometer (32) entnommen wird.

4. Ablenkverstärker nach einem der Ansprüche 1 oder 2, dadurch gekennzeichnet, daß die der Lage proportionale Spannung einem Spannungsteiler (25, 26, 27 ; 41, 42) entnommen wird, von dem zumindest ein Widerstand (30 ; 41, 42) dem Innenwiderstand des Rückkopplungseingangs des Verstärkers entspricht.

**Claims**

1. Deflection amplifier for deflection coils of a picture tube for visual display units, comprising a feed back circuit which is constructed as a resistance-diode network, one resistance being connected in parallel with at least one further resistance, the starting point of operation of which is determined by in each case one diode of preferably different breakdown voltage so that the resistance-diode network enters only partially into the feedback branch, characterised in that the position of the electron beam is adjustable and a voltage which is proportional to the change in the position of the electron beam is fed to the feedback branch (13) which displaces the starting point of the action of the diodes (34, 36) with the starting point of the change in gain in such a manner that the starting point is kept constant as the function of the position of the electron beam.

2. Deflection amplifier according to Claim 1, characterised in that the deflection current half-wave can be selected by means of the polarity of the diodes (34, 36).

3. Deflection amplifier according to one of Claims 1 or 2, characterised in that the voltage proportional to the position of the electron beam is taken from a position potentiometer (32).

4. Deflection amplifier according to one of Claims 1 or 2, characterised in that the voltage proportional to the position is taken from a voltage divider (25, 26, 27 ; 41, 42) of which at least one resistance (30 ; 41, 42) corresponds to the internal resistance of the feedback input of the amplifier.

**Revendications**

1. Amplificateur de déflexion pour les bobines de déflexion d'un tube-image pour un appareil de visualisation d'image avec branche de réaction réalisée sous la forme d'un réseau de résistance et de diodes, une résistance ayant au moins une autre résistance en parallèle, le point de fonctionnement étant chaque fois déterminé par une diode avec une tension de passage différente, de sorte que le réseau à résistance et diodes n'agit que partiellement sur la branche de réaction, caractérisé en ce que la position du faisceau d'électrons est réglable et on applique à la branche de réaction (13) une tension proportionnelle à la variation de position du faisceau d'électrons, tension qui déplace le point de mise en œuvre des diodes (34, 36) avec la variation du point de fonctionnement de l'amplificateur, et en ce que le point de fonctionnement est maintenu constant en fonction de la position du faisceau d'électrons.

2. Amplificateur de déflexion selon la revendication 1, caractérisé en ce que la polarité des diodes (34, 36) permet de choisir la demi-onde du courant de déflexion.

3. Amplificateur de déflexion selon l'une quelconque des revendications 1 ou 2, caractérisé en ce que la tension porportionnelle à la position du faisceau d'électrons est prise sur un potentiomètre de position (32).

4. Amplificateur de déflexion selon l'une des revendications 1 ou 2, caractérisé en ce que la tension proportionnelle à la position est prise sur un diviseur de tension (25, 26, 27 ; 41, 42) dont au moins une résistance (30 ; 41, 42) correspond à la résistance interne de l'entrée de réaction de l'amplificateur.

0 054 106

FIG. 1

FIG. 2

FIG. 4

FIG. 3